# EUROPEAN PATENT APPLICATION

(11) **EP 2 202 786 A1**
(43) Date of publication of application: **30.06.2010**
(21) Application number: 08839271.7
(22) Date of filing: 14.10.2008
(51) Int. Cl.: H01L 21/31, C23C 16/458, H01L 21/683

(54) **PLASMA FILM FORMING APPARATUS**

(30) Priority: 19.10.2007 JP 2007272233
(71) Applicant: Mitsubishi Heavy Industries, Ltd., Tokyo 108-8215 (JP)
(72) Inventor: KAFUKU, Hidetaka, Takasago-shi Hyogo 676-8686 (JP); SHIMAZU, Tadashi, Kobe-shi Hyogo 652-8585 (JP); MATSUDA, Ryuichi, Takasago-shi Hyogo 676-8686 (JP); MATSUKURA, Akihiko, Kobe-shi Hyogo 652-8585 (JP); NISHIKAWA, Seiji, Kobe-shi Hyogo 6528585 (JP)
(74) Representative: HOFFMANN EITLE
(86) International application number: PCT/JP2008/068525
(87) International publication number: WO 2009/051087

(57) **Abstract**

An object is to provide a plasma film forming apparatus capable of reducing particles even in the case in which a film is formed by applying a bias to a substrate. In the plasma film forming apparatus in which a bias is applied to a substrate (5) placed on a supporting table (4) in a chamber and forming a thin film on the substrate (5) by using plasma, the supporting table (4) has a columnar supporting table main body (4b) having a contact surface in contact with the substrate (5), the contact surface (4a) having an outer diameter (c) smaller than an outer diameter (W) of the substrate (5); and a flange portion (4c) extended in an outer circumferential direction from a side surface (4d) of the supporting table main body (4b); wherein a predetermined first gap (G1) is formed between the flange portion (4c) and a rear surface of the outer circumference of the substrate (5).

## Description

### TECHNICAL FIELD

The present invention relates to a plasma film forming apparatus which forms a thin film by using plasma.

### BACKGROUND ART

A plasma film forming apparatus which forms a thin film on a substrate (wafer) by using plasma is known. For example, in a plasma CVD apparatus, a wafer is placed on a supporting table in a vacuum chamber, the wafer is sucked and held by an electrostatic chuck provided on the supporting table, a desired gas is made into plasma, and a thin film is formed on the wafer by chemical vapor deposition (CVD: Chemical Vapor Deposition) of the gas, which has been made into plasma.
Patent Document 1: Japanese *Kohyo* Patent Publication No. 2001-508599

### DISCLOSURE OF THE INVENTION

### PROBLEMS TO BE SOLVED BY THE INVENTION

Along with increase of the degree of integration of integrated circuits, it has become necessary to embed an insulating film, etc. in fine grooves. For example, when a SiN (silicon nitride) film is to be embedded in fine grooves by using the plasma CVD apparatus, a film has to be formed by applying a bias to a wafer. However, when the film is formed by applying the bias to the wafer, there has been a problem that particles are increased.

The present invention has been accomplished in view of the foregoing problems, and it is an object of the present invention to provide a plasma film forming apparatus capable of reducing particles even in the case in which a film is formed by applying a bias to a substrate.

### MEANS FOR SOLVING THE PROBLEMS

A plasma film forming apparatus according to a first invention which solves the above described problems is
a plasma film forming apparatus applying a bias to a substrate placed on a supporting table in a chamber and forming a thin film on the substrate by using plasma, comprising:
   the supporting table has
   a columnar supporting table main body having a contact surface in contact with the substrate, the contact surface having an outer diameter smaller than an outer diameter of the substrate; and
   a flange portion extended in an outer circumferential direction from a side surface of the supporting table main body; wherein
   a predetermined first gap is formed between the flange portion and a rear surface of the outer circumference of the substrate.

A plasma film forming apparatus according to a second invention which solves the above described problems is
the plasma film forming apparatus according to the above described first invention, wherein
a peripheral portion of the contact surface is rounded up to the side surface of the supporting table main body.

A plasma film forming apparatus according to a third invention which solves the above described problems is
the plasma film forming apparatus according to the above described first or second invention, wherein
a base part of the flange portion is rounded up to the side surface of the supporting table main body.

A plasma film forming apparatus according to a fourth invention which solves the above described problems is
a plasma film forming apparatus applying a bias to a substrate placed on a supporting table in a chamber and forming a thin film on the substrate by using plasma, the plasma film forming apparatus comprising:
the supporting table has
a truncated-conical-shaped supporting table main body having a contact surface in contact with the substrate, the contact surface having an outer diameter smaller than an outer diameter of the substrate; wherein
a predetermined first gap is formed between an inclined side surface of the supporting table main body and a rear surface of the outer circumference of the substrate.

A plasma film forming apparatus according to a fifth invention which solves the above described problems is
a plasma film forming apparatus applying a bias to a substrate placed on a supporting table in a chamber and forming a thin film on the substrate by using plasma, the plasma film forming apparatus comprising:
the supporting table has
a columnar supporting table main body having a contact surface in contact with the substrate, the contact surface having an outer diameter smaller than an outer diameter of the substrate;
a flange portion extended in an outer circumferential direction from a side surface of the supporting table main body;
a fixing member holding the flange portion downward and fixing the supporting table main body to a supporting table lower part; and
a cover member placed on an upper surface of the fixing member and covering the upper surface of the fixing member; wherein
a predetermined first gap is formed between the fixing member and a rear surface of the outer circumference of the substrate; and
a predetermined second gap is formed between the cover member and an end portion of the outer circumference of the substrate.

A plasma film forming apparatus according to a sixth invention which solves the above described problems is
the plasma film forming apparatus according to the above described fifth invention, wherein
the second gap is within a range which is larger than 0.5 mm and equal to or less than 1.5 mm.

A plasma film forming apparatus according to a seventh invention which solves the above described problems is
the plasma film forming apparatus according to any one of the above described first to sixth inventions, wherein
the first gap is within a range which is equal to or more than 0.2 mm and equal to or less than 2 mm.

A plasma film forming apparatus according to an eighth invention which solves the above described problems is
the plasma film forming apparatus according to any one of the above described first to seventh inventions, wherein
the thin film is a nitride film.

### EFFECTS OF THE INVENTION

According to the first, fourth, seventh, and eighth inventions, the shape of the supporting table on which the substrate is placed is arranged. Therefore, reaching of the process gases to the rear surface of the substrate can be suppressed, and a thin film can be prevented from adhering to the supporting table-side, and a thin film can be prevented from adhering to the rear-surface-side inclined portion of the outer circumference of the substrate serving as a particle source. As a result, particles can be reduced. When the bias upon film formation is large, the influence caused by sputtering may be increased. However, by arranging the shape of the supporting table, the influence of sputtering can be suppressed, and thin film formation onto the rear-surface-side inclined portion of the outer circumference of the wafer serving as a particle source can be prevented. As a result, increase of the particles can be suppressed.

According to the second invention, damage of the rear surface of the substrate caused by frictions with the supporting table-side can be prevented, and, even if a thin film is formed on the rear surface of the substrate, the thin film can be prevented from being peeled off by the frictions.

According to the third invention, the strength of the flange portion can be improved.

According to the fifth, sixth, seventh, and eighth inventions, the shape of the supporting table on which the substrate is placed is arranged, and the fixing member and the cover member are disposed in the periphery of the substrate so that appropriate gaps are formed between them and the substrate. Therefore, reaching of the process gases to the rear surface of the substrate is suppressed, a thin film can be prevented from adhering to the supporting table-side and the fixing member-side, and a thin film can be prevented from adhering to the rear-surface side inclined portion of the outer circumference of the substrate serving as a particle source. As a result, particles can be reduced. When the bias upon film formation is large, the influence caused by sputtering may be increased. However, by arranging the shape of the supporting table and disposition of the fixing member and the cover member, the influence of sputtering can be suppressed, and thin film formation onto the rear-surface-side inclined portion of the outer circumference of the wafer serving as a particle source can be prevented. As a result, increase of the particles can be suppressed.

### BRIEF DESCRIPTION OF DRAWINGS

[FIG 1] A schematic configuration drawing showing an example of an embodiment of a plasma film forming apparatus according to the present invention.
[FIG. 2] A schematic configuration drawing showing a modification example of a supporting table shown in FIG. 2.
[FIG. 3] A schematic configuration drawing showing another modification example of the supporting table shown in FIG. 2.
[FIG. 4] A schematic configuration drawing showing another modification example of the supporting table shown in FIG. 2.
[FIG. 5] A schematic configuration drawing showing another modification example of the supporting table shown in FIG. 2.
[FIG. 6] A schematic configuration drawing showing a modification example of the constitution of the periphery of the supporting table shown in FIG. 2.
[FIG. 7] A graph showing variation of particles with respect to a gap G1 between a wafer and a fixing hardware.
[FIG. 8] A graph showing variation of particles with respect to a gap G2 between the wafer and a supporting table cover.
[FIG. 9] A drawing explaining the generation cause of particles.

### DESCRIPTION OF REFERENCE NUMERALS

4 SUPPORTING TABLE
4a CONTACT SURFACE
4b SUPPORTING TABLE MAIN BODY
4c FLANGE PORTION
4d SIDE SURFACE
4e, 4f CURVED SURFACE PORTION
4g INCLINED SIDE SURFACE
5 WATER
14 FIXING HARDWARE
15 SUPPORTING TABLE COVER

### BEST MODES FOR CARRYING OUT THE INVENTION

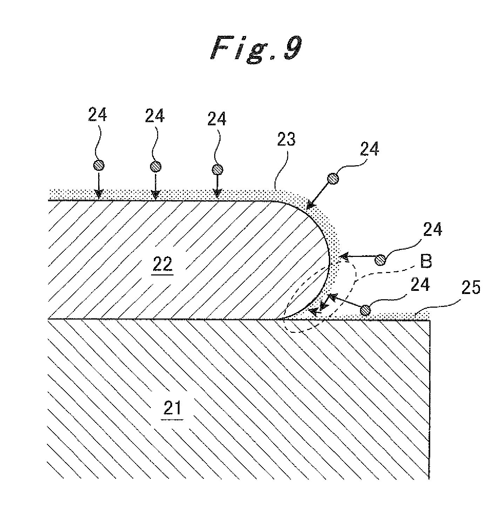

As described above, there has been a problem that particles are increased when a film is to be formed by applying a bias to a wafer, and there is an inclination that the particles in the thin film and on the surface of the thin film are increased particularly in the outer circumferential side of the wafer. The present inventors investigated the cause of the particle increase and found out that the thin film 23 is formed up to the part of a rear-surface-side inclined portion B of the outer circumference of the wafer 22 and that the thin film 23 of this part is peeled off and serves as the particle source (see FIG. 9).

When the bias is not applied to the wafer 22, the thin film 23 is not formed on the part of the rear-surface-side inclined portion B, and it has been confirmed that the thin film 23 is formed up to the part of the rear-surface-side inclined portion B only when the bias is applied to the wafer 22. Moreover, a supporting table 21, on which the wafer 22 is placed, is capable of sucking and holding the wafer 22 by an electrostatic chuck and applying a bias to the wafer 22, and, when film formation is carried out, a thin film 25 is also formed on the surface of the supporting table 21, which is outside the wafer 22. When these facts are taken into consideration, it can be expected that ions 24 drawn by the bias sputter the thin film 25, thereby forming the thin film 23 so that the thin film adheres to the part of the rear-surface-side inclined portion B. The thin film 23 of the part of the rear-surface-side inclined portion B formed in this manner has fragile and easily-peeled characteristics; therefore, it is conceived that this serves as the particle source and serves as the cause that increases the particles.

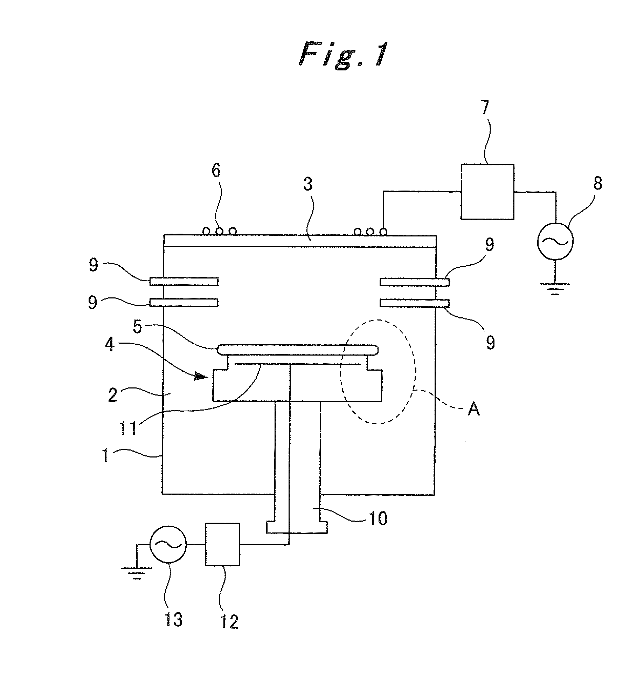

Therefore, when formation of the thin film 23 of the rear-surface-side inclined portion B serving as the particle source is prevented, the particles can be reduced even in the case in which a film is formed by applying a bias to the wafer 22. Therefore, in the present invention, formation of the thin film 23 on the rear-surface-side inclined portion B is prevented by arranging the shape of the supporting table 21. Hereinafter, embodiment examples of a plasma film forming apparatus according to the present invention will be explained with reference to FIG. 1 to FIG. 8.

### First Example

FIG. 1 is a schematic configuration drawing showing an example of the embodiment of the plasma film forming apparatus according to the present invention.
In the plasma film forming apparatus according to the present invention, as shown in FIG. 1, the interior of a cylindrical vacuum chamber 1 made of metal is formed as a processing chamber 2, and a circular-plate-like ceiling board 3 comprising an insulating material is disposed at an opening of an upper part of the vacuum chamber 1 so as to close the opening of the upper part. Moreover, a supporting table 4 and a lower supporting table 10 retaining the supporting table 4 are provided in a lower part of the vacuum chamber 1, and a wafer 5 (substrate) comprising a semiconductor material is placed on an upper surface of the supporting table 4. The vacuum chamber 1 comprises, for example, a metal such as aluminium, and the inner wall thereof has undergone alumite treatment, and the ceiling board 3 comprises, for example, ceramics such as alumina.

A high-frequency antenna 6 comprising, for example, a plurality of circular rings is disposed above the ceiling board 3, and a high-frequency (RF) power source 8 of the frequency of several hundred kHz to several hundred MHz is connected to the high-frequency antenna 6 via a matching box 7. Moreover, the vacuum chamber 1 is provided with a plurality of gas nozzles 9 which introduce a plurality of desired gases into the processing chamber 2.

Moreover, the supporting table 4 supporting the wafer 5 is provided with an electrode part 11, and the electrode part 11 is connected to a low-frequency (LF) power source 13 via a matching box 12. The low-frequency power source 13 applies a frequency that is lower than that of the high-frequency power source 8 to the electrode part 11 so that bias electric power can be applied to the wafer 5. Note that, although illustration is omitted, the supporting table 4 is also provided with an electrostatic chuck mechanism so that the wafer 5 can be sucked to and held by the surface of the supporting table 4 by feeding power from a power source for the electrostatic chuck.

In the plasma film forming apparatus of the above described constitution, when electric power is supplied to the high-frequency antenna 6, electromagnetic waves enter the vacuum chamber 1 via the ceiling board 3, and process gasses introduced into the vacuum chamber 1 via the gas nozzles 9 are made into plasma by the entered electromagnetic waves. Then, by using the process gases made into plasma, a thin film is formed on the wafer 5. For example, when a SiN film is to be formed, process gases of, for example, silane (SiH₄), ammonia (NH₃), and nitrogen (N₂) are used.

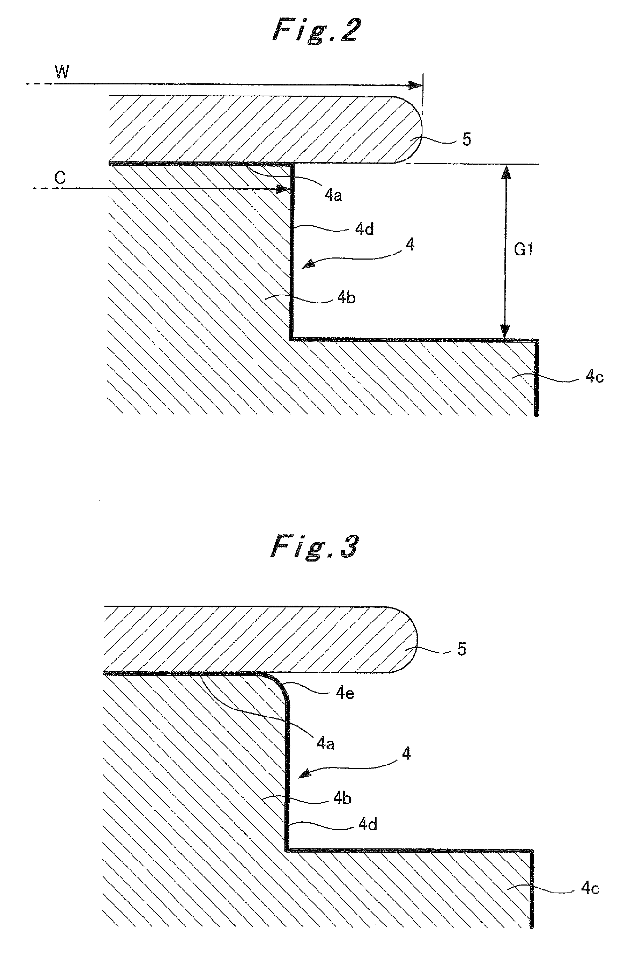

At this point, as described above, if the SiN film is to be embedded in fine grooves, the film has to be formed by applying a bias to the wafer 5; therefore, conventionally, the problem that particles are increased has been generated. In order to solve this problem, in the present invention, the shape of the supporting table 4 is arranged, thereby preventing formation of the thin film on the rear-surface-side inclined portion of the outer circumference of the wafer 5 that serves as the particle source. The specific shape thereof will be explained with reference to FIG. 2.

FIG. 2 is a schematic configuration drawing showing the specific shape of the supporting table 4 of the present example, and this is an enlarged drawing of a region A shown in FIG. 1.

As shown in FIG. 2, the supporting table 4 of the present example has a columnar supporting table main body 4b having a contact surface 4a, which is in contact with the wafer 5, and a flange portion 4c, which is provided to extend in the outer circumferential direction from a side surface 4d of the supporting table main body 4b, and the outer diameter C of the contact surface 4a is formed to be smaller than the outer diameter W of the wafer 5.

Since about 3 mm of the outer circumference of the wafer 5 is to be subjected to edge-cut, this part is not used for formation of devices. Therefore, the outer diameter C is required to be within the range of W>C≥W-(2×3 mm) in consideration of the area to be subjected to edge-cut. Furthermore, when the in-plane temperature uniformity of the wafer 5 is taken into consideration, it is desirably within the range of W>C≥W-(2×2 mm). Note that, in the present example, C=W-(2×1.8 mm), for example, if W is equal to 300 mm, C is equal to 296.4 mm.

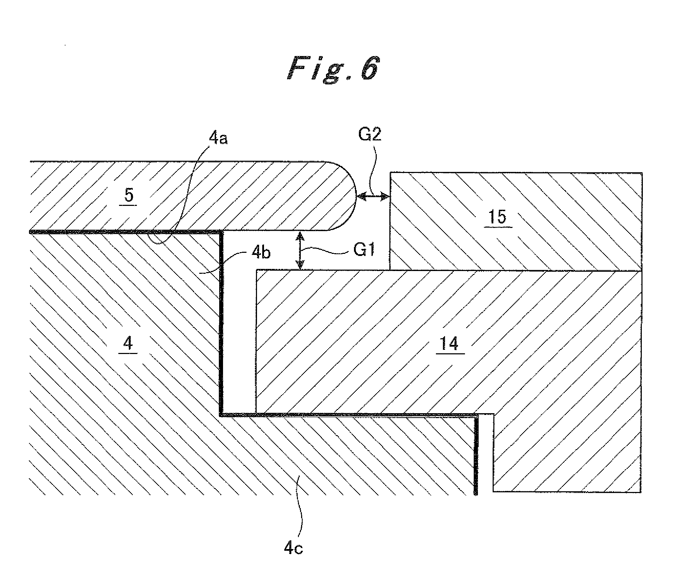

Moreover, a gap G1 (first gap) between the rear surface of the wafer 5 and the upper surface of the flange portion 4c is, as is explained in a later-described fifth example, required to have the distance by which the sputtered thin film does not readily adhere to the wafer 5 and the process gases do not readily reach the rear surface side, and the gap is set to be within the range of, for example, 2 mm≥G1≥0.2 mm. An object of the flange portion 4c is to form an appropriate gap between the flange portion and the rear surface of the wafer 5. When such an appropriate gap is formed, the contact surface 4a is prevented from being present at a position close to the rear-surface-side inclined portion of the outer circumference of the wafer 5, and reaching of the process gases to the rear surface side of the wafer 5 is suppressed. In this manner, in the present example, at the supporting table main body 4b, the appropriate gap G1 which prevents being close to the rear-surface-side inclined portion of the outer circumference of the wafer 5 and suppresses reaching of the process gases to the rear surface side of the wafer 5 is provided at a position corresponding to the edge-cut portion of the outer circumference of the wafer 5. Note that, when the supporting table 4 is to be provided with the electrostatic chuck mechanism, as shown in FIG. 6 which is described later, the flange portion 4c can be used as a clamp part for fixing it to the lower supporting table 10.

In the present example, by causing the supporting table 4 to have the above described shape, reaching of the process gases to the rear surface of the substrate 5 is suppressed, and the thin film is prevented from being readily formed on the flange portion 4c; moreover, even when a thin film is formed on the upper surface of the flange portion 4c and sputtered by the ions drawn by bias, the thin film does not readily reach the rear surface side of the wafer 5; as a result, thin-film formation on the rear-surface-side inclined portion of the outer circumference of the wafer 5 serving as the particle source can be prevented, and, eventually, particles upon film formation are reduced.

### Second Example

FIG. 3 is a schematic configuration drawing showing a modification example of the supporting table 4 shown in the first example (FIG. 2). Note that, herein, the elements having the same constitutions as FIG. 2 are denoted by the same reference numerals, and redundant explanations thereof are omitted.

As shown in FIG. 3, in the present example, a curved surface portion 4e having a curved shape (round shape) is further provided between the contact surface 4a and the side surface 4d of the supporting table 4, thereby rounding a peripheral portion of the contact surface 4a up to the side surface 4d, and the corner part of the peripheral portion of the contact surface 4a shown in FIG. 2 of the first example is eliminated in this constitution. This is for the reason that, since the supporting table is generally formed of an insulating material such as AlN (aluminum nitride) in the case of the supporting table 4 having the electrostatic chuck function and has a thermal expansion coefficient different from that of the wafer 5 comprising a semiconductor material such as Si (silicon), frictions may be generated by thermal expansion and may serve as a cause of particle generation under the condition in which the corner part of the contact surface 4a is present and is in contact with the rear surface of the wafer 5.

Therefore, by providing the curved surface portion 4e at the periphery of the contact surface 4a of the supporting table 4, in addition to the effects of the first example, damage of the rear surface of the wafer 5 caused by frictions with the supporting table 4-side is prevented, and, even when a thin film is formed on the rear surface of the wafer 5, the thin film is prevented from being peeled off by the frictions.

### Third Example

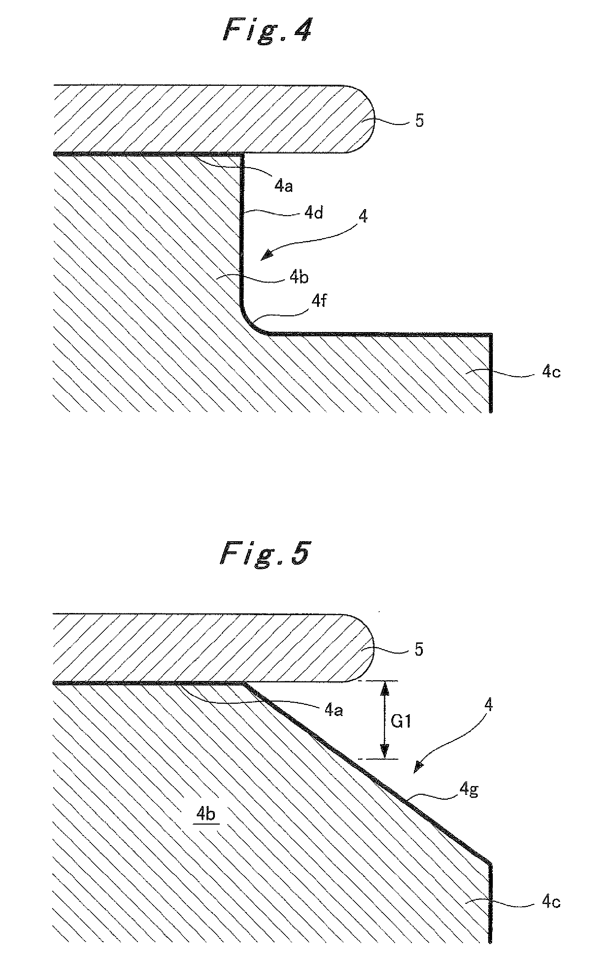

FIG. 4 is also a schematic configuration drawing showing a modification example of the supporting table 4 shown in the first example (FIG. 2). Note that, also in this example, the elements having the same constitutions as FIG. 2 are denoted by the same reference numerals, and the redundant explanations thereof are omitted.

As shown in FIG. 4, in the present example, a curved surface portion 4f having a curved shape (round shape) is further provided between the flange portion 4c and the side surface 4d of the supporting table 4, thereby rounding a base part of the flange portion 4c up to the side surface 4d, and the corner part of the base part of the flange portion 4c shown in FIG. 2 of the first example is eliminated in this constitution. This is for the reason that, although the supporting table is generally formed of an insulating material such as AlN that does not have high strength in the case of the supporting table 4 having the electrostatic chuck function, the strength of the flange portion 4c can be ensured by providing the curved surface portion 4f.

Therefore, by providing the curved surface portion 4f at the base part of the flange portion 4c of the supporting table 4, in addition to the effects of the first example, the strength of the flange portion 4c can be improved, and this is effective, for example, particularly in the case in which the flange portion 4c is fixed by using fixing hardware 14 as shown in FIG. 6 which is described later.

Note that the constitution in which both the curved surface portion 4e and the curved surface portion 4f are provided by combining the third example and the above described second example may be employed.

### Fourth Example

FIG. 5 is also a schematic configuration drawing showing a modification example of the supporting table 4 shown in the first example (FIG. 2). Note that, also in this example, the elements having the same constitutions as FIG. 2 are denoted by the same reference numerals, and the redundant explanations thereof are omitted.

As shown in FIG. 5, the present example is the constitution in which the lower side to the flange portion 4c of the supporting table 4 has a columnar shape, the upper side thereof has a truncated conical shape so as to form an inclined side surface 4g, and the upper surface thereof serves as the contact surface 4a. In other words, instead of causing the upper surface of the flange portion 4c to be a horizontal surface, the side surface of the supporting table main body 4b is constituted to be the inclined side surface 4g having the inclination that connects the corner part of the contact surface 4a and the corner part of the flange portion 4c. The upper surface of the flange portion 4c is not required to be horizontal like this, and the upper surface may have a tapered shape like that shown in FIG. 5 as long as an appropriate gap can be formed between the upper surface and the rear surface in the outer circumferential side of the wafer 5. The gap between the rear surface in the outer circumferential side of the wafer 5 and the inclined side surface 4g is required to have the distance by which the sputtered thin film does not readily adhere to the wafer 5 and the process gases do not readily reach the rear surface side; and, as well as the first example, the distance between the rear surface in the outer circumferential side of the wafer 5 and the inclined side surface 4g which is vertically below it is desired to be the gap G1 in a predetermined range (2 mm≥G1≥0.2 mm).

Also in the present example, by causing the supporting table 4 to have the above described shape, reaching of the process gases to the rear surface of the substrate 5 is suppressed, a thin film is prevented from being formed readily on the inclined side surface 4g, and, in addition, even when the thin film is formed on the surface of the inclined side surface 4g and the thin film is sputtered by the ions drawn by bias, the thin film does not readily reach the rear surface side of the wafer 5; as a result, formation of the thin film on the rear surface side inclined portion of the outer circumference of the wafer 5 which serves as the particle source can be prevented. Furthermore, in the case of the supporting table 4 having the electrostatic chuck function, the strength of the supporting table 4 per se can be ensured by employing the tapered shape, and, when the supporting table 4 is to be fixed by clamping, it can be readily and reliably fixed by using fixing hardware having a shape corresponding to the tapered shape. Fifth Example

FIG. 6 is also a schematic configuration drawing showing a modification example of the supporting table 4 shown in the first example (FIG. 2). Note that, also in this example, the elements having the same constitutions as FIG. 2 are denoted by the same reference numerals, and the redundant explanations thereof are omitted.

As shown in FIG. 6, in the present example, in the periphery of the supporting table 4 shown in FIG. 2 of the first example, furthermore, the fixing hardware 14 (fixing member) made of metal which clamps the upper surface of the flange portion 4c and a supporting table cover 15 (cover member) which is placed on the upper surface of the fixing hardware 14 and covers the upper surface of the fixing hardware 14 are provided. The fixing hardware 14 has a ring-like shape having an L-shaped cross section and is formed of, for example, aluminium, and the surface thereof has undergone alumite treatment. The supporting table 4 is held down toward the lower supporting table 10-side by the flange portion 4c, thereby fixing the supporting table 4. The supporting table cover 15 has a ring-like shape having a rectangular cross section, is formed of, for example, high-purity alumina, and is for protecting the surface of the fixing hardware 14 from plasma. The supporting table cover 15 is disposed at a position so that the surface thereof is at a height position approximately same as the surface of the wafer 5, in further detail, so that the position of the surface of the supporting table cover 15 is higher than the rear-surface-side inclined portion of the outer circumference of the wafer 5 and lower than the surface of the wafer 5.

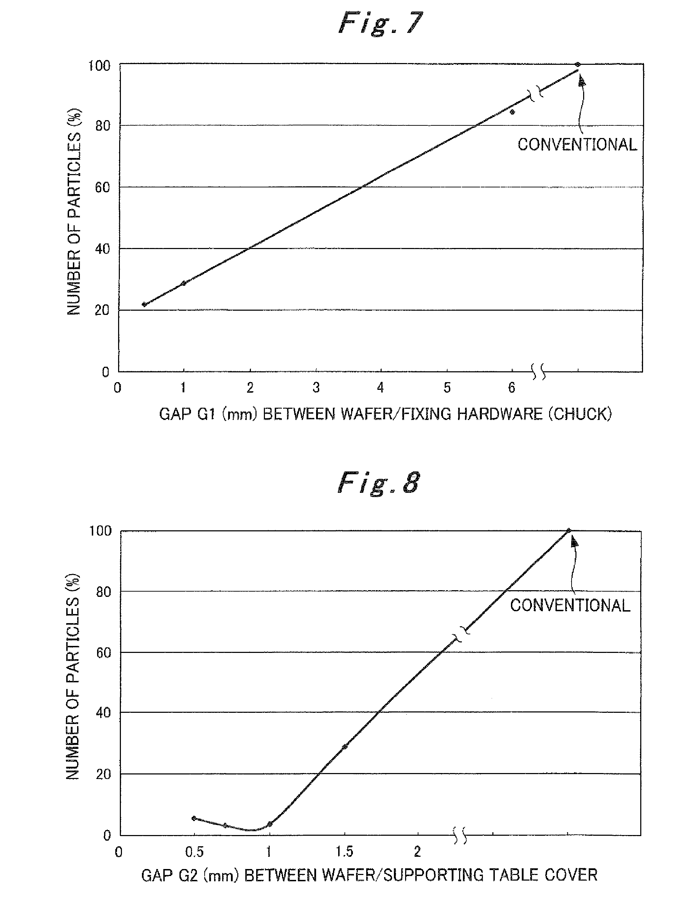

In addition, in the present example, the fixing hardware 14 is disposed in the rear-surface side of the wafer 5 so that the gap G1 between the rear surface of the wafer 5 and the upper surface of the fixing hardware 15 is in a predetermined range. As shown in FIG. 7, there is a tendency that particles are increased when the gap G1 is too large, and the number of particles is sufficiently small compared with conventional cases when the gap G1 is 2 mm or less, desirably, 1 mm or less. This is for the reason that reaching of the process gases to the rear surface of the wafer 5 is suppressed when the gap G1 is shortened, and, as a result, a thin film can be prevented from being formed on the rear-surface-side inclined portion of the outer circumference of the wafer 5 serving as a particle source. On the other hand, when the gap G1 is too small, the wafer 5 and the fixing hardware 14 may contact with each other and cause frictions; therefore, the gap G1 is desired to be 0.2 mm or more so that a reliable gap can be ensured in consideration of processing accuracy. Note that, in FIG. 7, it is shown in comparison wherein a conventional number of particles is assumed to be 100%.

The range of the numerical value of the above described gap G1 can be also applied to the case in which the fixing hardware 14 and the supporting table cover 15 are not present, in other words, the constitutions of the above described first example (FIG. 2) to fourth example (FIG. 5), and in that case, the gap G1 between the rear surface of the wafer 5 and the upper surface of the flange portion 4c (in the case of the fourth example, the gap G1 between the rear surface of the wafer 5 and the inclined side surface 4g) is 2 mm or less, desirably, 1 mm or less, and is required to be 0.2 mm or more.

Therefore, by causing the periphery of the supporting table 4 to have the above described constitution, furthermore, the process gases can be prevented from flowing to the rear surface of the wafer 5, film formation onto the upper surfaces of the flange portion 4c and the fixing hardware 14 can be prevented, and, since there is no thin film to be sputtered even when sputtering occurs, sputtered matters do not adhere to the wafer 5-side. As a result, thin film formation onto the rear-surface-side inclined portion of the outer circumference of the wafer 5 can be prevented, and, eventually, particles upon film formation are reduced.

### Sixth Example

The present example is a modification example of the above described fifth example, and the constitution thereof is equivalent to the constitution shown in FIG. 6 of the fifth example. Therefore, herein, explanations will be given with reference to FIG. 6 and FIG. 8.

As well as the fifth example, the present example also has the constitution in which the fixing hardware 14 and the supporting table cover 15 are further provided in the periphery of the supporting table 4. In the fifth example, merely the gap G1 between the rear surface of the wafer 5 and the upper surface of the fixing hardware 14 is specified, and a gap G2 (second gap) between an outer circumferential end portion of the wafer 5 and the inner diameter of the supporting table cover 15 is not specified in the constitution.

On the other hand, in the present example, the gap G2 having a doughnut shape in a top view is provided, and the supporting table cover 15 is disposed in the outer circumferential-side of the wafer 5 so that the gap G2 is in a predetermined range. The inner diameter of the supporting table cover 15 is, as a matter of course, larger than the outer diameter W of the wafer 5, and, as shown in FIG. 8, there is a tendency that particles are increased when the gap G2 is too large, and a sufficiently small number of particles compared with conventional cases is obtained when the gap G2 is 1.5 mm or less. This is for the reason that reaching of the process gases to the rear surface of the wafer 5 is suppressed when the gap G2 is shortened, and, as a result, thin film formation onto the rear-surface-side inclined portion of the outer circumference of the wafer 5 serving as a particle source can be prevented. As a lower limit value of the gap G2, it is desired to be larger than 0.5 mm so that frictions with the supporting table cover 15 can be reliably avoided in consideration of the accuracy of conveyance (±0.5 mm), etc. of the wafer 5 to the supporting table 4. Note that, also in FIG. 8, it is shown in comparison wherein the conventional number of particles is assumed to be 100%.

When film formation was carried out while varying the gap G2 and then the rear-surface-side inclined portion of the outer circumference of the wafer 5 was observed by an optical microscope, in the case in which the gap G2 was larger than 1.5 mm, a thin film adhered to that part, and generation of blisters was perceived. However, when the gap G2 was 1.5 mm or less, blisters were not generated in that part. Therefore, it was confirmed that there is an effect of reducing particles.

Therefore, by causing the periphery of the supporting table 4 to have the above described constitution, furthermore, the process gases can be prevented from flowing to the rear surface of the wafer 5, film formation onto the upper surfaces of the flange portion 4c and the fixing hardware 14 can be prevented, and, even when sputtering occurs, sputtered matters do not adhere to the wafer 5-side since there is no thin film to be sputtered. As a result, thin film formation onto the rear-surface-side inclined portion of the outer circumference of the wafer 5 can be prevented, and, eventually, particles upon film formation are reduced.

Note that, the present example can be combined with the above described fifth example, wherein the fixing hardware 14 and the supporting table cover 15 are required to be disposed so that the gaps G1 and G2 are within the above described ranges.

### INDUSTRIAL APPLICABILITY

The present invention can be applied to a plasma film forming apparatus which forms a thin film by using plasma and is particularly suitable for a plasma CVD apparatus which forms a SiN film by applying a bias.

## Claims

1. A plasma film forming apparatus applying a bias to a substrate placed on a supporting table in a chamber and forming a thin film on the substrate by using plasma, comprising:
the supporting table has
a columnar supporting table main body having a contact surface in contact with the substrate, the contact surface having an outer diameter smaller than an outer diameter of the substrate; and
a flange portion extended in an outer circumferential direction from a side surface of the supporting table main body; wherein
a predetermined first gap is formed between the flange portion and a rear surface of the outer circumference of the substrate.

2. The plasma film forming apparatus according to claim 1, wherein
a peripheral portion of the contact surface is rounded up to the side surface of the supporting table main body.

3. The plasma film forming apparatus according to claim 1 or claim 2, wherein
a base part of the flange portion is rounded up to the side surface of the supporting table main body.

4. A plasma film forming apparatus applying a bias to a substrate placed on a supporting table in a chamber and forming a thin film on the substrate by using plasma, comprising:
the supporting table has
a truncated-conical-shaped supporting table main body having a contact surface in contact with the substrate, the contact surface having an outer diameter smaller than an outer diameter of the substrate; wherein
a predetermined first gap is formed between an inclined side surface of the supporting table main body and a rear surface of the outer circumference of the substrate.

5. A plasma film forming apparatus applying a bias to a substrate placed on a supporting table in a chamber and forming a thin film on the substrate by using plasma, comprising:
the supporting table has
a columnar supporting table main body having a contact surface in contact with the substrate, the contact surface having an outer diameter smaller than an outer diameter of the substrate;
a flange portion extended in an outer circumferential direction from a side surface of the supporting table main body;
a fixing member holding the flange portion downward and fixing the supporting table main body to a supporting table lower part; and
a cover member placed on an upper surface of the fixing member and covering the upper surface of the fixing member; wherein
a predetermined first gap is formed between the fixing member and a rear surface of the outer circumference of the substrate; and
a predetermined second gap is formed between the cover member and an end portion of the outer circumference of the substrate.

6. The plasma film forming apparatus according to claim 5, wherein
the second gap is within a range which is larger than 0.5 mm and equal to or less than 1.5 mm.

7. The plasma film forming apparatus according to any one of claim 1 to claim 6, wherein
the first gap is within a range which is equal to or more than 0.2 mm and equal to or less than 2 mm.

8. The plasma film forming apparatus according to any one of claim 1 to claim 7, wherein
the thin film is a nitride film.
